(19) Europäisches Patentamt / European Patent Office / Office européen des brevets

(11) **EP 1 739 825 B1**

(12) **FASCICULE DE BREVET EUROPEEN**

(45) Date de publication et mention
de la délivrance du brevet:
**15.10.2008 Bulletin 2008/42**

(51) Int Cl.:
***H03D 3/00*** *(2006.01)*

(21) Numéro de dépôt: **06368011.0**

(22) Date de dépôt: **29.06.2006**

(54) **Procédé de correction automatique de l'inversion spectrale dans un démodulateur et dispositif pour mettre en oeuvre le procédé**

Demodulator with automatic correction of a detected spectral inversion , and device

Verfahren zur Demodulation unter Verwendung von automatischer Korrigierung einer spektralen Inversion sowie Vorrichtung

(84) Etats contractants désignés:
**DE FR GB IT**

(30) Priorité: **01.07.2005 FR 0507040**

(43) Date de publication de la demande:
**03.01.2007 Bulletin 2007/01**

(73) Titulaire: **STMicroelectronics S.A.**
**92120 Montrouge (FR)**

(72) Inventeur: **Meyer, Jacques**
**38950 Saint-Martin-Le-Vinoux (FR)**

(74) Mandataire: **Schuffenecker, Thierry**
**120 Chemin de la Maure**
**06800 Cagnes sur Mer (FR)**

(56) Documents cités:
**WO-A-01/86902** **GB-A- 2 282 286**

**Description**

**Domaine technique de l'invention**

La présente invention concerne le domaine des transmissions numériques et plus spécialement un procédé de correction automatique de l'inversion spectrale dans un démodulateur d'un système de transmission numérique.

**Etat de la technique**

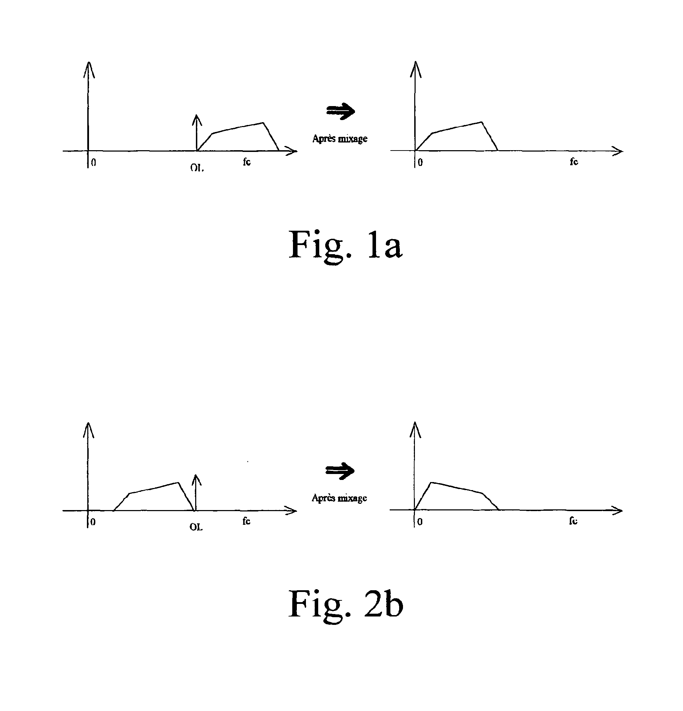

Les communications numériques connaissent un essor considérable avec la téléphonie mobile, les nouveaux standards de télévision numérique et les transmissions par satellite. Les progrès significatifs dans ce domaine et la grande diversité des opérateurs ont fait de l'information un bien aussi facile à échanger que peut l'être une marchandise.
Cette grande diversion des opérateurs dans la chaîne de transmission a introduit le besoin, au sein du décodeur d'un système de communication numérique de détecter, outre les paramètres classiques de synchronisation de temps et de phase, un paramètre supplémentaire qui est celui de l'inversion spectrale.
Comme cela est connu et illustré en figure 1a, lors d'une démodulation, un récepteur effectue le mélange du spectre du signal reçu avec une fréquence porteuse (OL). Selon que cette porteuse est à une fréquence inférieure ou supérieure au spectre de la fréquence à traiter, il peut y avoir une inversion du spectre. La figure 1a illustre une situation normale dans laquelle il n'y a aucune inversion spectrale introduite.

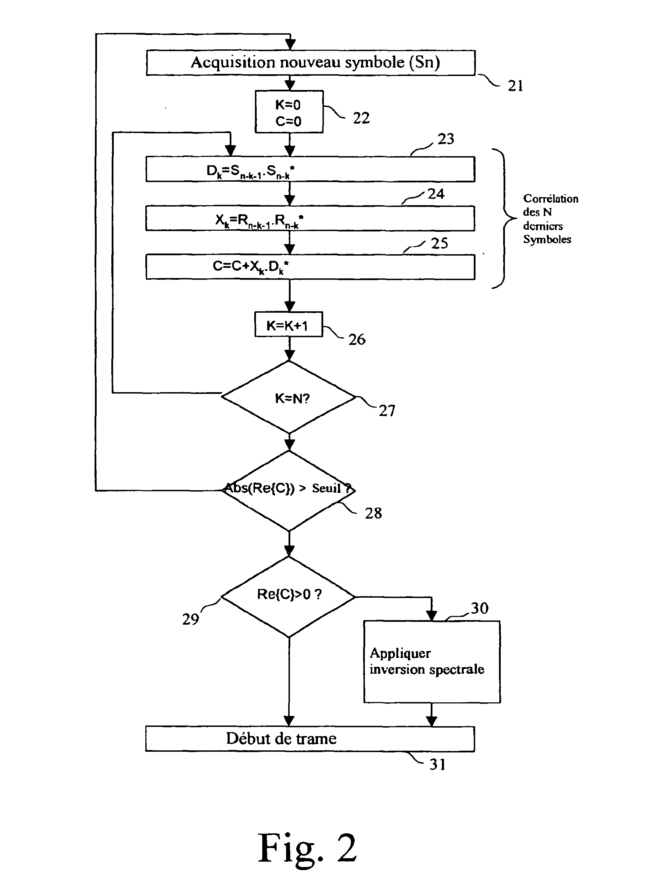

La figure 2b illustre au contraire une situation dans laquelle le spectre de fréquences a subi une inversion. Cette inversion n'est guère gênante lorsque le spectre du signal à transmettre est parfaitement symétrique comme cela est le cas pour une modulation d'amplitude.
En revanche, lorsque la modulation est plus complexe, une inversion spectrale rend impossible la détection de données. Bien que le détecteur soit calée sur la fréquence de la porteuse grâce aux boucles d'asservissement de phase *(Phase Locked Loop* dans la littérature anglo-saxonne), la réception de données est rendue impossible dans le cas d'une inversion spectrale.
Ce problème doit être corrigé et ce d'autant plus que, dans les télécommunications numériques modernes, de multiples modulations/démodulations peuvent affecter le signal à transmettre et à recevoir et que, en outre, divers opérateurs sont susceptibles d' intervenir sur ce même signal.
On corrige l'inversion spectrale de deux manières : soit en inversant le signal reçu sur la porteuse en quadrature, soit en inversant les deux canaux en phase et en quadrature après une rotation de $\pi/2$.
D'une manière classique, la plupart des systèmes prévoient de remédier à une éventuelle inversion spectrale au moyen d'une inversion par voie logicielle des canaux en phase et en quadrature du signal démodulé. A cet effet, le récepteur classique « présume » lors du traitement d'un signal reçu que ce signal n'est pas affecté par une quelconque inversion spectrale. Si la détection échoue alors qu'il est synchronisé sur la porteuse, le récepteur détermine alors, au bout d'un certain temps, qu'une inversion spectrale a pu intervenir et effectue une inversion des canaux en phase et en quadrature pour rétablir le spectre originel.
Ce mécanisme universellement connu donne satisfaction jusqu'à un certain point, mais présente l'inconvénient d'introduire un temps de latence rédhibitoire dans le traitement du signal démodulé pour les applications les plus modernes.
Le brevet GB 2 282 286 est un exemple de réalisation connue comportant un récepteur radio, avec un étage RF et un étage à bande de base comportant un processeur de traitement de signal destiné à introduire une inversion spectrale du signal passant au travers de l'étage radio lorsqu'il s'avère une inversion est à corriger.
Il serait souhaitable de remédier àcette situation en permettant une détection quasi-immédiate d'une inversion spectrale dans un signal reçu afin d'en assurer le traitement instantané.

**Exposé de l'invention**

La présente invention a pour but de proposer un procédé de correction automatique de l'inversion spectrale dans un démodulateur d'un système de transmission numérique.
Un autre but de la présente invention consiste à proposer un procédé de correction de l'inversion spectrale particulièrement rapide, et adapté à l'usage de la modulation $\pi/2$ BPSK.
L'invention réalise ces buts au moyen d'un procédé de correction de l'inversion spectrale pour un récepteur dans un système de communication numérique tel que défini dans la revendication 1. Le procédé permet la réception dans le récepteur d'une séquence d'apprentissage supposée connue suivant une modulation de type $\pi/2$ BPSK ou MDP2. Le procédé comporte les étapes suivantes :

- démodulation de ladite séquence d'apprentissage ;

- calcul de corrélation différentielle effectuée sur une fenêtre de N échantillons reçus ($R_n$) et N échantillons présumés envoyés ($S_n$);
- utilisation du résultat de corrélation pour déterminer, en même temps, la détection du début de trame et si une inversion spectrale doit être introduite dans la chaîne de réception numérique.

De préférence, on utilise le module dudit résultat que l'on compare à un seuil pour déterminer le début de trame et l'on teste le signe du même résultat pour commander une inversion spectrale dans la chaîne de réception.

Dans un mode de réalisation préféré, le procédé met en oeuvre plusieurs modulation, dont une modulation de type $\pi/2$ BPSK (ou MDP2) est utilisé pour déterminer la commande d'une inversion spectrale.

Dans un mode de réalisation particulier, le procédé est appliqué à une communication numérique suivant la norme DVBS2 *(Digital Video Broadcasting Satellite)* comportant plusieurs blocs et symboles ayant des modulations différentes, dont une partie fait l'objet d'une modulation de type $\pi/2$ BPSK .

L'invention permet également la réalisation d'un récepteur pour un système de communication numérique comportant un dispositif d'inversion spectrale tel que défini dans la revendication 10, comportant :

- des moyens de réception d'une séquence d'apprentissage supposée connue suivant une modulation de type $\pi/2$ BPSK ou MDP2;
- des moyens permettant de démoduler ladite séquence d'apprentissage ;
- des moyens permettant un calcul de corrélation différentielle sur un ensemble de N échantillons reçus ($R_n$) et présumés envoyés ($S_n$)
- des moyens pour utiliser le résultat dudit calcul différentiel pour simultanément déterminer le début de trame et pour commander l'activation d'une inversion spectrale dans la chaîne de réception.

De préférence, la valeur absolue de la partie réelle du résultat sert à déterminer le bloc de début de trame et le signe de ce même partie réelle du résultat est utilisé pour commander une inversion spectrale dans la chaîne de réception.

L'invention est particulièrement adaptée à la réalisation d'un récepteur et d'un système de réception conforme à la norme DVBS2 , ou toute norme utilisant des blocs et symboles transmis suivant des modulations distinctes, dont une modulation de type $\pi/2$ BPSK.

## Description des dessins

D'autres caractéristiques, but et avantages de l'invention apparaîtront à la lecture de la description et des dessins ci-après, donnés uniquement à titre d'exemples non limitatifs. Sur les dessins annexés :

La figure 1 a une situation de démodulation d'un signal par une porteuse (OL) dans laquelle il n'est produit aucune inversion spectrale.

La figure 1b illustre une situation de démodulation d'un signal avec une inversion spectrale.

La figure 2 représente un procédé de correction d'une inversion spectrale conforme à la présente invention.

La figure 3 illustre un mode de réalisation d'un dispositif permettant la mise en oeuvre du procédé décrit.

## Description d'un mode de réalisation préféré

Le procédé de correction de l'inversion spectrale est basée sur l'utilisation d'une séquence d'apprentissage — comportant une séquence $S_0$, $S_1$, $S_2$, $S_3$ .... supposée connue en combinaison avec une modulation à déplacement de phase à 2 états (MDP2), également désignée par l'appellation *Binary Phase Shift Keying* (BPSK) dans la littérature anglo-saxonne. Comme on le sait, dans la modulation MDP2 ou BPSK, la constellation est composée des deux points 1 et - 1 seulement. Dans le procédé suivant l'invention, on utilise plus particulièrement la version dite $\pi/2$ BPSK de cette modulation (ou $\pi/2$ MDP2) dans laquelle, les symboles de rang pair sont transmis sur la porteuse en phase tandis que les symboles de rangs impairs sont transmis sur la porteuse en quadrature. Cette modulation présente l'avantage de distribuer l'énergie de manière uniforme sur les deux canaux, en phase et en quadrature, ce qui assure une meilleure transmission dans certains cas et notamment au travers des amplificateurs non linéaires des satellites de communication.

Il est à noter que, dans un mode de réalisation préféré, la modulation de type $\pi/2$ BPSK est appliquée sur une partie seulement de l'information traitée, étant entendu qu'une autre partie de l'information pourra faire l'objet de modulations différentes. L'homme du métier pourra clairement adapter le procédé de l'invention à toutes variantes ou toutes combinaisons de modulations et même lorsque la modulation de type $\pi/2$ BPSK est appliquée à l'intégralité du signal à transmette/émettre.

La figure 2 montre le procédé de correction selon l'invention qui est appliqué dans un récepteur selon l'invention. Le procédé est basé sur l'utilisation d'une séquence d'apprentissage reçue et traitée par un récepteur exécutant le procédé qui suit :

Dans une <u>étape 21</u>, le procédé selon l'invention calcule un symbole différentiel $D_n$ calculé comme suit à partir de deux symboles consécutif transmis $S_n$ et Sn+1 :

$$D_n = S_n \cdot S_{n+1}{}^\star$$

<u>L'étape 22</u> est une étape d'initialisation des indices d'itération k et C, lesquels sont mis à 0.

On entre ensuite dans une boucle itérative formée par les étapes 23 et 26, boucle dans laquelle on calcule successivement un symbole différentiel d'émission Dk, un symbole différentiel de réception Xk et le résultat d'un calcul de corrélation leur correspondant.

A cet effet, le procédé effectue dans un étape 23 le calcul d'un symbole différentiel d'émission $D_k$ à partir de deux symboles consécutifs d'émission $D_{n-k-1}$ et $D_{n-k}$ pour la valeur de k considérée.

Puis, dans <u>une étape 24,</u> le procédé selon l'invention calcule un symbole différentiel $X_n$ à partir de deux symboles consécutifs reçus $R_{n-k-1}$ et $R_{n-k}$

$$X_n = R_{n-k-1} \cdot R_{n-k}{}^\star$$

Dans une <u>étape 25</u>, le procédé effectue le produit des valeurs $X_k$ et $D_k$ calculées précédemment et ajoute le produit à la variable C :

$$C = C + X_k \cdot D_k{}^\star$$

Ainsi, le calcul de l'étape 25 conduit à un calcul de corrélation différentielle basée sur une fenêtre de N échantillons $X_0...X_{N-1}$ et N échantillons $D_0...D_{N-1}$ comme suit :

$$C = \sum_{k=0}^{N-1} X_k \cdot D_k^{\bullet}$$

<u>Dans une étape 26</u>, le procédé itère la variable k et, dans une <u>étape 27</u> un test est effectué pour déterminer si k = N, ce qui indiquerait l'aboutissement du calcul de corrélation sur les N dernières valeurs.

Si k est différent de N dans l'étape 26, le procédé effectue une nouvelle boucle de calcul en réitérant les étapes 23-27. Dans le cas contraire, lorsque k = N, alors le procédé poursuit avec <u>une étape 28</u> où le procédé teste le résultat du calcul précédent et compare la valeur absolue du résultat de l'étape 25 avec un seuil prédéterminé. Il est à noter que le seuil est fixé de manière classique pour permettre la détection du début de trame dans un récepteur de communication numériques. La manière de le fixer ne sera donc pas développée plus avant.

Si le module (ou bien la valeur absolue de la partie réelle) n'atteint pas le seuil prédéterminé, alors le procédé retourne à l'étape 21 pour traiter un nouveau jeu de symboles.

Dans le cas ou la valeur absolue de la partie réelle du résultat est supérieure au seuil, alors le procédé poursuit avec <u>une étape 29</u> au cours de laquelle le procédé teste le signe de cette partie réelle du résultat du calcul de corrélation différentiel.

Si le signe est positif le procédé , le procédé poursuit avec <u>une étape 27</u> qui est le déclenchement de la détection du début de trame.

Si le signe est négatif, le procédé poursuit avec une <u>étape 30</u> où, sans attendre l'expiration d'un quelconque temps de latence, une inversion spectrale est appliquée dans la chaîne de réception. Il est à noter que l'application de l'inversion spectrale est faite suivant une manière connue et qui pourra emprunter, selon le cas, soit une voie logicielle, soit une voie matérielle.

Le procédé poursuit ensuite avec l'étape 31 du lancement du début de trame.

Ainsi, comme on le voit, le procédé suivant l'invention permet de traiter en même temps aussi bien un signal reçu ayant subi une inversion spectrale dans la chaîne de transmission qu'un signal de réception exempt d'une telle inversion. En utilisant le signe du calcul de corrélation différentiel, le récepteur peut, dans le cas d'une modulation de type π/2 BPSK , le signe peut être directement et avantageusement mis à profit pour immédiatement provoquer une inversion spectrale et lancer la détection du début de trame.

Il en résulte un avantage considérable, à savoir un temps de traitement insignifiant de l'inversion spectrale laquelle exigeait, jusqu'à présent, le redémarrage du récepteur après un temps de latence prédéfini. Avec l'invention, le calcul de corrélation différentielle effectué permet immédiatement, et sans que l'on connaisse a priori l'existence ou non d'une inversion spectrale au moment où l'on démarre le calcul de corrélation différentielle, de lancer le détecteur sur le début de trame.

C'est un effet particulièrement remarquable du procédé décrit que de permettre ce traitement instantané de l'inversion spectrale. On constate en effet que les symboles différentiels sont :

$$D_{2k} = (b_{2k}).(j\, b_{2k+1})^* = -j\, b_{2k}\,.\, b_{2k+1} \quad (\text{où les b sont réels})$$

D étant un nombre imaginaire pur, on constate donc que $D^* = -D$

Ainsi, comme on peut le voir, lorsqu'une inversion spectrale intervient dans la chaîne de transmission, le calcul de corrélation effectué à l'étape 25 conduit à un résultat C' qui correspond tout simplement à l'opposé du conjugué du résultat obtenu sans inversion spectrale, comme le montre la formule :

$$C' = \sum_{k=0}^{N-1} X_k^* . D_k^* = -\sum_{k=0}^{N-1} X_k^* . D_k = -C^*$$

Il en découle ainsi que, dans l'hypothèse d'une modulation π/2 BPSK , il n'est pas besoin de réitérer un nouveau calcul de corrélation. Le résultat peut directement être utilisé, dans les deux situations, pour lancer la détection du début de trame.

Le procédé qui vient d'être décrit peut être implémenté de diverses manières, et notamment par voie purement logicielle

Le procédé peut être avantageusement utilisé dans le cas d'une communication conforme à la nouvelle norme DVBS2 (*Digital Video Broadcasting Satellite*) qui sera utilisée en Europe pour la transmission vidéo par satellite. Conformément à cette norme, le signal reçu est une succession de blocs de symboles ayant des longueurs et des modulations distinctes. Au début de chaque bloc transmis, un en-tête est transmis pour définir le format des symboles qui suivent. Le décodage de cet en-tête est essentiel pour garantir la bonne réception des blocs suivants. Il est composé de 90 symboles, dont 26 comportent une information connue (SOF = *start of frame* ), et 64 symboles supplémentaires (PLS = *Physical Layer Structure*) codant 7 bits, soit 128 mots possibles, dont la structure permet d'accroitre la fiabilité de la détection d'un départ de trame.

Les 64 symboles de PLS permettent d'éviter des faux départs. Dans le mode de réalisation préféré, on effectue le traitement décrit sur les 26 symboles de SOF et l'on compare la valeur absolue du résultat par rapport à un seuil prédéfini pour déterminer le départ de trame, et le signe l'inversion spectrale. Clairement, il ne s'agit que d'un mode de réalisation et un homme du métier pour effectuer d'autres tests supplémentaires et bien connus pour limiter les faux départs. A noter que, dans certains cas, le codage de PLS est connu au moins partiellement, ce qui permet d'augmenter le nombre de symboles différentiels connus (si on connaît l'information « pilot » de DVBS2, on peut utiliser 32 symboles de plus)

Suivant la norme DVBS2, ces 90 bits font l'objet d'une modulation de type π/2 BPSK

On constate ainsi que , dans la nouvelle norme de télédiffusion de vidéo par satellite, on pourra judicieusement mettre à profit le procédé de correction de l'inversion spectrale, en appliquant ce procédé à l'en-tête modulé suivant la modulation π/2 BPSK .

Il ne s'agit pourtant qu'une des nombreuses possibilités de l'invention.

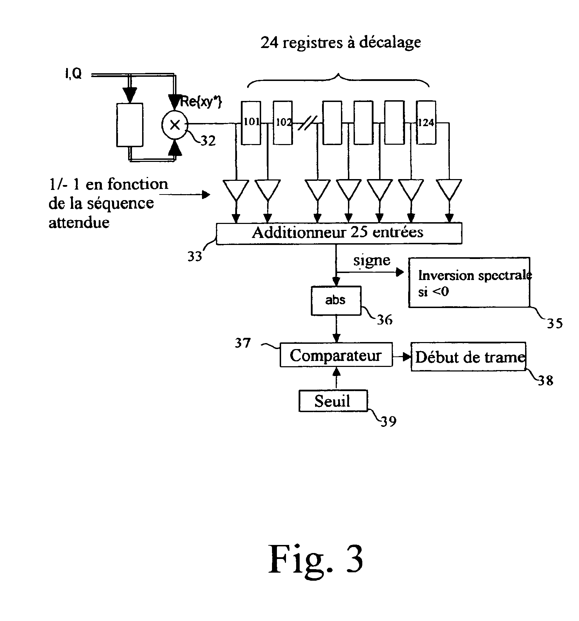

La figure 3 illustre un mode de réalisation basé sur un jeu de 24 registres à décalages 101-124 recevant la partie réelle Re (xy*) du signal reçu en sortie d'un multiplieur 32. Chaque sortie est ensuite inversée ou non suivant la séquence différentielle émise. Un additionneur à 25 entrées 33 permet de générer la somme de ces valeurs et les transmettre à un bloc 36 permettant de générer la valeur absolue du résultat.

Les résultats des blocs 36 est comparé à un seuil 39 au moyen d'un bloc comparateur 37, afin de permettre la détection du début de trame par le détecteur 38.

Comme on le voit sur la figure 3, le signe du calcul effectué par le bloc 35 permet de detecter l'inversion spectrale et de la corriger immédiatement.

## Revendications

1. Procédé de correction de l'inversion spectrale pour un récepteur dans un système de communication numérique, ledit procédé comportant la réception, par ledit récepteur d'une séquence d'apprentissage supposée connue suivant une modulation de type π/2 BPSK ou MDP2 et **caractérisé en ce qu'**il comporte les étapes suivantes :

   - démodulation de ladite séquence d'apprentissage ;
   - calcul (21,22, 23) de corrélation différentielle sur un ensemble de N échantillons reçus ($R_n$) et présumés envoyés ($S_n$) pour générer un résultat ;
   - utilisation du résultat de corrélation pour détecter le début de trame et l'utilisation du signe dudit résultat pour commander une inversion spectrale dans la chaîne de réception numérique.

2. Procédé selon la revendication 1 **caractérisé en ce qu'**il comporte les étapes suivantes :

   - calcul de la valeur absolue de la partie réelle dudit résultat de corrélation différentielle pour déterminer le début de trame ;
   - test sur le signe de ladite partie réelle du résultat pour commander une inversion spectrale dans la chaîne de réception.

3. Procédé selon la revendication 1 **caractérisé en ce qu'**il est appliqué à une communication numérique combinant une modulation de type π/2 BPSK (ou π/2 MDP2) appliquée sur une partie du signal reçu et une modulation d'un autre type.

4. Procédé de démodulation la revendication 3 **caractérisé en ce qu'**il est utilisé pour une communication de type DVBS2 *(Digital Video Broadcasting Satellite)* comportant plusieurs blocs et symboles ayant des modulations différentes, dont une partie fait l'objet d'une modulation de type π/2 BPSK .

5. Procédé de démodulation selon la revendication 4 **caractérisé en ce que** l'en-tête comporte un ensemble de 90 symboles transmis via une modulation de type π/2 BPSK dont au moins 26 sont connus.

6. Récepteur pour un système de communication numérique comportant un dispositif d'inversion spectrale, **caractérisé en ce qu'**il comporte :

   - des moyens de réception d'une séquence d'apprentissage supposée connue suivant une modulation de type π/2 BPSK ou π/2 MDP2 ;
   - des moyens permettant de démoduler ladite séquence d'apprentissage ;
   - des moyens permettant un calcul de corrélation différentielle sur un ensemble de N échantillons reçus ($R_n$) et présumés envoyés ($S_n$)
   - des moyens pour utiliser le résultat dudit calcul différentiel pour simultanément déterminer le début de trame et pour commander l'activation d'une inversion spectrale dans la chaîne de réception.

7. Récepteur selon la revendication 6 **caractérisé en ce qu'**il comporte :

   - des moyens de calcul de la valeur absolue de la partie réelle dudit résultat de corrélation différentielle pour déterminer le début de trame ;
   - des moyens pour commander une inversion spectrale en fonction du signe de ladite partie réelle du résultat.

8. Récepteur selon la revendication 6 **caractérisé en ce qu'**il combine des moyens permettant de traiter une partie seulement d'une information modulée suivant une modulation de type π/2 BPSK (ou π/2 MDP2).

9. Récepteur selon la revendication 8 comportant des moyens pour traiter plusieurs blocs et symboles ayant des modulations différentes, dont une partie fait l'objet d'une modulation de type π/2 BPSK .

10. Système de communication numérique comportant un récepteur doté d'un dispositif d'inversion spectrale, **caractérisé en ce qu'**il comporte :

 - des moyens de réception d'une séquence d'apprentissage supposée connue suivant une modulation de type $\pi/2$ BPSK ou $\pi/2$ MDP2 ;
 - des moyens permettant de démoduler ladite séquence d'apprentissage ;
 - des moyens permettant un calcul de corrélation différentielle sur un ensemble de N échantillons reçus ($R_n$) et présumés envoyés ($S_n$)
 - des moyens pour utiliser le résultat dudit calcul de corrélation différentielle pour simultanément déterminer le début de trame et pour commander l'activation d'une inversion spectrale dans la chaîne de réception.

**Claims**

1. Process of correction of spectral inversion for a receiver in a digital communication system, said process comprising the reception, by the aforementioned receiver of a training sequence presumedly known according to a of $\pi/2$ BPSK type modulation (or MDP2) and further comprising the following steps:

 - demodulation of said training sequence;
 - calculation (21,22, 23) of differential correlation on a set of N received samples ($R_n$) and presumedly sent ($S_n$) to generate a result;
 - Use of said result of correlation to detect the beginning (start) of the frame and the sign of said result in order to control a spectral inversion in the chain of digital reception.

2. Process according to claim 1 **characterized by** the following steps:

 - calculation of the absolute value of the real part of said result of the differential correlation in order to determine the start of the frame;
 - test on the sign of said real part of the result in order to control a spectral inversion in the reception chain.

3. Process according to claim 2 **characterized in** what it is applied to a digital communication combining a $\pi/2$ BPSK (or MDP2) type modulation applied on a part of the received signal and a modulation of another type.

4. Process of demodulation according to claim 3 **characterized in** what it is used for DVBS2 *(Digital Video Broadcasting Satellite)* type communication comprising several blocks and symbols having different modulations, of which a part is subject to a modulation of type $\pi/2$ BPSK .

5. Process of demodulation according to claim 4 **characterized in** what the heading comprises a set of 90 symbols transmitted via a modulation of type $\pi/2$ BPSK of which at least 26 are known.

6. Receiver for a digital communication system comprising a device for spectral inversion, **characterized in that** it comprises:

 - means of reception of a presumedly known training sequence according to a modulation type $\pi/2$ BPSK or MDP2;
 - means for demodulating said training sequence;
 - means for calculating a differential correlation on a set of N received samples ($R_n$) and presumedly sent ($S_n$)
 - means for utilising the result of said differential calculation to simultaneously determine the beginning of the frame and to control a spectral inversion in the chain of reception.

7. Receiver according to claim 6 **characterized in** what it comprises:

 - means for calculating the absolute value of the real part of said result of the differential correlation to determine the beginning of the frame
 - means for controlling a spectral inversion according to the sign of said real part of the result.

8. Receiver according to claim 7 **characterized in** what it combines means for processing part of a information modulated according to a $\pi/2$ BPSK (or $\pi/2$ MDP2) type modulation.

9. Receiver according to claim 8 comprising means to process several blocks and symbols having different modulations, of which a part is subject to a $\pi/2$ BPSK type modulation.

10. Digital communication system comprising a receiver equipped with a spectral inversion device, **characterized in that** it comprises:

- means of reception of a presumedly known training sequence according to a $\pi/2$ BPSK (or $\pi/2$ MDP2) modulation type;
- means for demodulating said training sequence;
- means for calculating a differential correlation on a set of N received samples ($R_n$) and presumedly sent ($S_n$)
- means for utilising the result of said differential calculation to simultaneously determine the beginning of the frame and for controlling a spectral inversion in the chain of reception.

**Patentansprüche**

1. Verfahren zur automatischen Korrigierung der spektralen Inversion für einen Empfänger in einem digitalen Kommunikationssystem, wobei das besagte Verfahren den Empfang einer als bekannt vorausgesetzten Lernsequenz durch den besagten Empfänger gemäß einer Modulation des Typs $\pi/2$ BPSK oder MDP2 beinhaltet und **dadurch gekennzeichnet ist, dass** es folgende Schritte aufweist:

- Demodulation der besagten Lernsequenz;
- Berechnung (21, 22, 23) der differenziellen Korrelation über eine Menge von N empfangenen Proben ($R_n$), die zur Generierung eines Ergebnisses als gesendete Proben ($S_n$) vorausgesetzt werden;
- Verwendung des Ergebnisses der Korrelation, um den Anfang des Datenübertragungsblocks zu ermitteln, und Verwendung des Vorzeichens des besagten Ergebnisses, um in der digitalen Empfangskette eine spektrale Inversion zu bewirken.

2. Verfahren gemäß Anspruch 1, **dadurch gekennzeichnet, dass** es folgende Schritte aufweist:

- Berechnung des absoluten Werts des realen Anteils des besagten Ergebnisses der differenziellen Korrelation, um den Anfang des Datenübertragungsblocks zu bestimmen;
- Test zum Vorzeichen des besagten realen Anteils am Ergebnis, um in der Empfangskette eine spektrale Inversion zu bewirken.

3. Verfahren gemäß Anspruch 1, **dadurch gekennzeichnet, dass** es auf eine digitale Kommunikation angewendet wird, wobei eine auf einen Teil des empfangenen Signals angewendete Modulation des Typs $\pi/2$ BPSK (oder $\pi/2$ MDP2) und eine Modulation eines anderen Typs kombiniert werden.

4. Verfahren zur Demodulation gemäß Anspruch 3, **dadurch gekennzeichnet, dass** es für eine Kommunikation des Typs DVBS2 *(Digital Video Broadcasting Satellite)* verwendet wird, die mehrere Blöcke und Symbole mit unterschiedlichen Modulationen enthält, von denen ein Teil Gegenstand einer Modulation des Typs $\pi/2$ BPSK ist.

5. Verfahren zur Demodulation gemäß Anspruch 4, **dadurch gekennzeichnet, dass** der Header eine Menge von 90 Symbolen umfasst, die anhand einer Modulation des Typs $\pi/2$ BPSK übertragen werden und von denen mindestens 26 bekannt sind.

6. Empfänger für ein digitales Kommunikationssystem, das eine Vorrichtung zur spektralen Inversion enthält, **dadurch gekennzeichnet, dass** es aufweist:

- Mittel zum Empfang einer als bekannt vorausgesetzten Lernsequenz gemäß einer Modulation des Typs $\pi/2$ BPSK oder $\pi/2$ MDP2;
- Mittel, mit denen die Demodulation der besagten Lernsequenz ermöglicht wird,
- Mittel, mit denen eine differenzielle Korrelation über eine Menge von N empfangenen Proben ($R_n$) und als gesendet vorausgesetzten Proben ($S_n$) berechnet werden kann;
- Mittel zur Verwendung des Ergebnisses der besagten differenziellen Berechnung für die Bestimmung des Anfangs des Datenübertragungsblocks und gleichzeitig für den Befehl zur Aktivierung einer spektralen Inversion in der Empfangskette.

**7.** Empfänger gemäß Anspruch 6, **dadurch gekennzeichnet, dass** er aufweist:

- Mittel zur Berechnung des absoluten Werts des realen Anteils am besagten Ergebnis der differenziellen Korrelation, um den Anfang des Datenübertragungsblicks zu bestimmen;
- Mittel zur Bewirkung einer spektralen Inversion abhängig vom Vorzeichen des besagten realen Anteils am Ergebnis.

**8.** Empfänger gemäß Anspruch 6, **dadurch gekennzeichnet, dass** er Mittel kombiniert, die die Verarbeitung nur eines Teils einer anhand einer Modulation des Typs $\pi/2$ BPSK (oder $\pi/2$ MDP2) modulierten Information ermöglicht.

**9.** Empfänger gemäß Anspruch 8, der Mittel enthält, um mehrere Blöcke und Symbole mit unterschiedlichen Modulationen zu verarbeiten, von denen ein Teil Gegenstand einer Modulation des Typs $\pi/2$ BPSK ist.

**10.** Digitales Kommunikationssystem, das einen mit einer Vorrichtung zur spektralen Inversion ausgestatteten Empfänger enthält, **dadurch gekennzeichnet, dass** es aufweist:

- Mittel zum Empfang einer als bekannt vorausgesetzten Lernsequenz gemäß einer Modulation des Typs $\pi/2$ BPSK oder $\pi/2$ MDP2;
- Mittel, mit denen die Demodulation der besagten Lernsequenz ermöglicht wird;
- Mittel, mit denen eine differenzielle Korrelation über eine Menge von N empfangenen Proben ($R_n$) und als gesendet vorausgesetzten Proben ($S_n$) berechnet werden kann;
- Mittel zur Verwendung des Ergebnisses der besagten Berechnung der differenziellen Korrelation für die Bestimmung des Anfangs des Datenübertragungsblocks und gleichzeitig für den Befehl zur Aktivierung einer spektralen Inversion in der Empfangskette.

Après mixage

Fig. 1a

Après mixage

Fig. 2b

Fig. 2

24 registres à décalage

I,Q

Re{xy*}

×

32

101 102 // 124

1/- 1 en fonction
de la séquence
attendue

Additionneur 25 entrées

33

signe

Inversion spectrale
si <0

abs

36

35

37

Comparateur

Début de trame

38

Seuil

39

Fig. 3

**EP 1 739 825 B1**

## RÉFÉRENCES CITÉES DANS LA DESCRIPTION

**Documents brevets cités dans la description**

- GB 2282286 A